# EUROPEAN PATENT SPECIFICATION

(11) **EP 0 726 598 B1**
(45) Date of publication and mention of the grant of the patent: **07.04.2004**
(21) Application number: 96200045.1
(22) Date of filing: 10.01.1996
(51) Int. Cl.: H01L 21/56

(54) **Moulding apparatus with compensation element**
Giessvorrichtung mit Kompensationselement
Appareil de moulage à élément de compensation

(30) Priority: 09.02.1995 NL 9500238
(43) Date of publication of application: 14.08.1996
(73) Proprietor: FICO B.V., 6921 RW Duiven (NL)
(72) Inventor: Peters, Gerardus F.W., NL-6924 SC Loo (NL); Peters, Hendrikus J.B., NL-6942 GP Didam (NL)
(74) Representative: Van den Heuvel, Henricus Theodorus

(56) References cited:
- PATENT ABSTRACTS OF JAPAN vol. 017, no. 661 (E-1471), 7 December 1993 & JP-A-05 218508 (SHARP CORP), 27 August 1993,
- PATENT ABSTRACTS OF JAPAN vol. 016, no. 488 (E-1277), 9 October 1992 & JP-A-04 179130 (HITACHI TOKYO ELECTRON CO LTD), 25 June 1992,
- PATENT ABSTRACTS OF JAPAN vol. 018, no. 317 (M-1622), 16 June 1994 & JP-A-06 071685 (TOSHIBA CORP), 15 March 1994,

## Description

The invention relates to a moulding apparatus as disclosed in the preamble of claim 1.

Such a moulding apparatus is known from the Japanese patent JP 05 218508. The moulding apparatus according this patent is provided with pressing parts that are pressed floatable to the wiring pattern on a substrate carrying a semiconductor device. The pressing parts are urged to the substrate by springs. Pressing parts and springs are integrated in a die of the moulding apparatus. Although substrates with a thickness that is not precisely known can be processed with such a device this processing is not fully controlled as the clamping force of the pressing parts is dependent on the thickness.

The present invention has for its object to provide a moulding apparatus for moulding a chip on a flat carrier which variations in the thickness of the carrier can controlled be compensated.

The present invention provides for this purpose a moulding apparatus as disclosed in claim 1. Use of this moulding apparatus enables controlled processing of carriers of varying thickness; by displacement of the beam the force exerted on the carrier can be regulated independent of the thickness. It hereby becomes possible not only to use less expensive carriers but also to use carriers of a material with a relative great thickness toleration. This makes it possible for example to use printed circuit board material as carriers.

The present invention will further elucidated with reference to the non-limitative embodiments shown in the following figures. Herein:
figure 1 shows, only as an example useful for understanding the invention, a partly cut away perspective view of a moulding apparatus with a segment supported by springs, and
figure 2 shows a partly cut away perspective view of a moulding apparatus with clamping device.

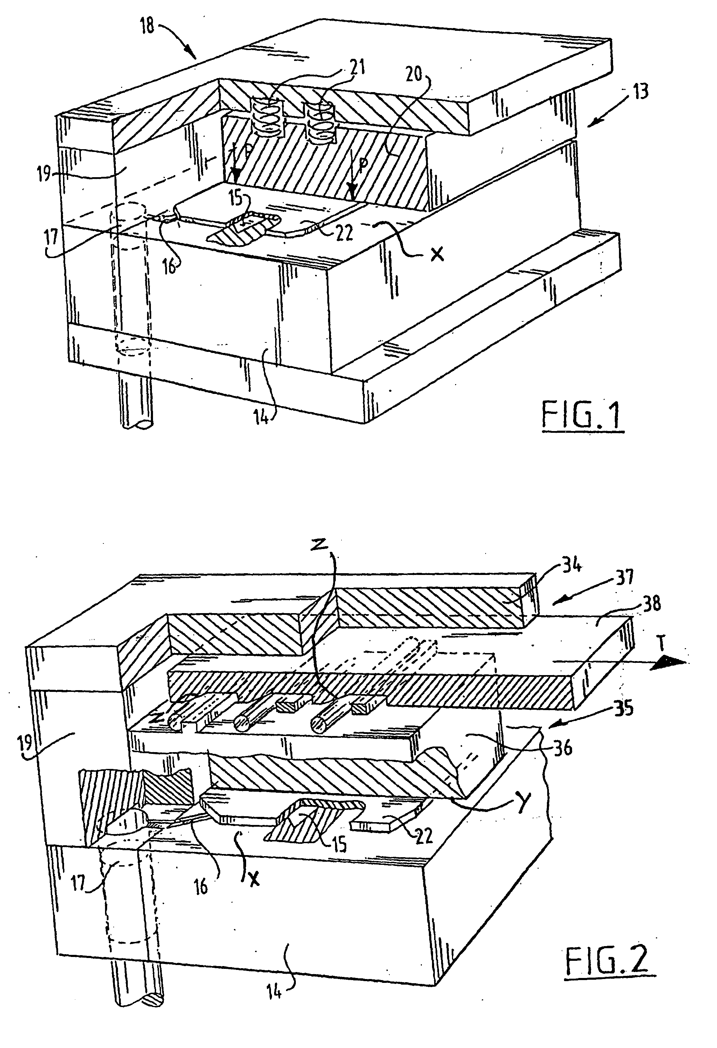

Figure 1 shows a prior art moulding apparatus 13 in which a lower mould part 14 is provided with a mould cavity 15 and, communicating therewith, a runner 16 which is then connected to a supply device 17 for moulding material. An upper mould part 18 comprises two segments 19, 20 moveable relative to each other. The segments 19, 20 are mutually connected with interposing of springs 21. The mould parts 14, 18 close precisely onto each other close to the supply device 17 irrespective of the thickness of a carrier 22. The force exerted on the carrier 22 by the segment 20 as according to arrows P depends on the spring constants of the spring 21. The springs 21 thus determine with what force the carrier 22 is pressed against the lower mould part 14, without this having to depend on the thickness of the carrier 22, wherein the thickness of the carrier 22 also has no influence on the connection of the mould parts 14, 18 close to the supply device 17 for moulding material.

Figure 2 shows a moulding apparatus 35 in which a carrier 22 is received between two mould parts 14, 18 on which carrier 22 is arranged a chip for moulding (not shown in this figure). In a surface (x) of the lower mould part 14 is arranged a mould cavity 15 in which a covering element can be arranged through a runner 16 by exerting pressure on moulding material 7 using a plunger 17. In order to prevent moulding material leaking to the outside at a parting between the mould parts 14, 18, the mould halves 14, 18 must connect together precisely. For this purpose the mould halves 14, 18 are pressed against each other with a predetermined force. To now ensure that the carrier 22 is enclosed non-movably between the mould parts 14, 18, i.e. irrespective of differences in the thickness of the carrier 22 a compensation element 37 in the form of a clamping device is arranged in the upper mould part 18. This compensation element 37 presses the carrier against a peripheral edge 24 of the surface (x) of the lower mould part 14.

A segment 36 of the mould part 18 is connected to a holding plate 34 with interposing of a clamping device 37. The segment 36 is urged further downward relative to holding plate 34 by displacing a beam 38 as according to arrow T. Depending on the force exerted in the direction of arrow T, it is possible to vary the force which a surface (y) of the segment 36 exerts on carrier 22. The embodiment of the beam 38 shown here has of course many alternatives. Wedge-shaped elements (z) are envisaged here as an example. With this preferred embodiment it is also possible to move mould part 14 and segment 19 to within a short distance of each other in order to effect the definitive connection of segment 19. to mould part 14 after the segment 36 has already been brought into contact with carrier 26.

## Claims

1. Moulding apparatus (35) for moulding a chip on a flat carrier (22), comprising:
- a mould comprising a first mould part (14) and a second mould part (18), said first and second mould parts (14, 18) being movable relative to each other and between which the carrier (22) can be received;
- a mould cavity (15) provided at a surface (x) of said first mould part (14), said mould cavity (15) having peripheral edges (24) to which the carrier (22) can be pressed;
- a supply device (17) for exerting pressure to moulding material (7), said supply device (17) being provided in one of the first and second mould parts (14, 18);
- a runner (16) provided at said surface (x) of said first mould part (14), said runner (16) interconnecting said supply device (17) and said mould cavity (15);
- the second mould part (18) comprises a first segment (36), a second segment (19) and a holding plate (34), said first segment (36) being interposed between said surface (x) of said first mould part (14) and said holding plate (34), said first segment (36) being movable relative to said second segment (19) and having a segment surface (y) opposed to said surface (x) of said first mould part (14);
- a clamping device (37) interposed between said first segment (35) and said holding plate (34), said clamping device (37) being adapted for holding, in a closed position of the mould parts (14, 18), the carrier (22) sealingly against said peripheral edge (24) and said segment surface (y);
**characterised in that**,
said clamping device (37) comprises, a displaceable beam (38) having a surface comprising a wedge shaped protrusion (z), said displaceable beam (38) being interposed between said holding plate (34) and said first segment (36) such that displacement of said displaceable beam (38) varies a force which said first segment (36) exerts upon the carrier (22).

## Patentansprüche

1. Gießvorrichtung (35) zum Einkapseln eines Chips auf einem flachen Träger (22), bestehend aus:
- einer Gießform, die ein erstes Formteil (14) und ein zweites Formteil (18) umfasst, wobei besagtes erste und zweite Formteil (14,18) relativ zueinander beweglich sind und zwischen welchen der Träger (22) aufgenommen werden kann;
- einem Formhohlraum (15), der an der Fläche (x) des besagten ersten Formteils (14) vorgesehen ist, besagter Formhohlraum (15) besitzt Umfangskanten (24), gegen die der Träger (22) gepresst werden kann;
- einer Zufuhrvorrichtung (17) zur Ausübung von Druck auf eine Formmasse (7), besagte Zufuhrvorrichtung (17) ist in einem der ersten und zweiten Formteile (14,18) vorgesehen;
- einem Angusskanal (16), der an der besagten Fläche (x) des besagten ersten Formteils (14) vorgesehen ist, besagter Angusskanal (16) verbindet besagte Zufuhrvorrichtung (17) mit besagtem Formhohlraum (15);
- das zweite Formteil (18) umfasst ein erstes Segment (36), ein zweites Segment (19) und eine Halteplatte (34), besagtes erste Segment (36) befindet sich zwischen besagter Fläche (x) des ersten Formteils (14) und besagter Halteplatte (34), besagtes erste Segment (36) ist relativ zum zweiten Segment (19) beweglich und besitzt eine Segmentfläche (y), die der besagten Fläche (x) des besagten ersten Formteils (14) gegenübersteht;
- einer Spannvorrichtung (37), die sich zwischen dem ersten Segment (35) und der besagten Halteplatte (34) befindet, besagte Spannvorrichtung (37) ist angepasst, um in einer geschlossenen Stellung der Formteile (14,18) den Träger (22) dichtend gegen besagte Umfangskante (24) und besagte Segmentfläche (y) zusammenzuhalten;
**dadurch gekennzeichnet, dass** besagte Spannvorrichtung (37) einen verschiebbaren Balken (38) umfasst, der eine Oberfläche mit einem keilförmigen Vorsprung (z) besitzt, besagter verschiebbarer Balken (38) befindet sich zwischen besagter Halteplatte (34) und besagtem ersten Segment (36), derart dass ein Verschieben des besagten verschiebbaren Balkens (38) eine Kraft verändert, die besagtes Segment (36) auf den Träger (22) ausübt.

## Revendications

1. Appareil de moulage (35) pour mouler une puce sur un support plat (22), comprenant :
- un moule constitué d'une première partie de moule (14) et d'une seconde partie de moule (18), lesdites première et seconde parties de moule (14, 18) étant mobiles l'une par rapport à l'autre et le support (22) pouvant être reçu entre elles ;
- une cavité de moule (15) ménagée sur une surface (x) de ladite première partie de moule (14), ladite cavité de moule (15) ayant des bords périphériques (24) contre lesquels le support (22) peut être pressé ;
- un dispositif d'alimentation (17) pour exercer une pression sur un matériau de moulage (7), ledit dispositif d'alimentation (17) étant ménagé dans l'une desdites première et seconde parties de moule (14, 18) ;
- un canal de coulée (16) ménagé à ladite surface (x) de ladite première partie de moule (14), ledit canal de coulée (16) reliant ledit dispositif d'alimentation (17) et ladite cavité de moule (15) ;
- la seconde partie de moule (18) comprenant un premier segment (36), un second segment (19) et une plaque de fixation (34), ledit premier segment (36) étant interposé entre ladite surface (x) de ladite première partie de moule (14) et ladite plaque de fixation (34), ledit premier segment (36) étant mobile par rapport audit second segment (19) et ayant une surface segmentaire (y) opposée à ladite surface (x) de ladite première partie de moule (14) ;
- un dispositif de serrage (37) interposé entre ledit premier segment (35) et ladite plaque de fixation (34), ledit dispositif de serrage (37) étant adapté pour maintenir de manière étanche, lorsque les parties de moule (14, 18) sont dans une position fermée, le support (22) contre ledit bord périphérique (24) et ladite surface segmentaire (y) ;
**caractérisé en ce que :**
ledit dispositif de serrage (37) comprend un plateau déplaçable (38) ayant une surface comprenant une saillie en forme de coin (z), ledit plateau déplaçable (38) étant interposé entre ladite plaque de fixation (34) et ledit premier segment (36) de telle sorte que le déplacement dudit plateau déplaçable (38) fait varier une force que ledit premier segment (36) exerce sur le support (22).
